# EUROPEAN PATENT APPLICATION

(11) **EP 2 863 427 A1**
(43) Date of publication of application: **22.04.2015**
(21) Application number: 13189301.8
(22) Date of filing: 18.10.2013
(51) Int. Cl.: H01L 23/49, H01L 21/66

(54) **Array formed from a multiplicity of electric integrated circuits, and method for production thereof**

(71) Applicant: Micro Systems Engineering GmbH, 95180 Berg (DE)
(72) Inventor: Krenkel, Michael, 71665 Vaihingen (DE); Brandl, Albert, 95145 Oberkotzau (DE); Goßler, Jörg, 95213 Münchberg (DE)
(74) Representative: Lindner-Vogt, Karin L.

(57) **Abstract**

The invention relates to an array (1) formed from a multiplicity of electric integrated circuits (1a), comprising a conductive connection, extending over all integrated circuits of the array, to a central contact path for bond monitoring, wherein a separation region (2) is provided in each case between adjacent integrated circuits (1a) and a separation from the array (1) is implemented along the separation region in order to separate the integrated circuits (1a). In order to avoid corrosion of electric circuits (1a) produced from the array (1), at least one conductive connection portion (3) is provided and extends between two contact paths (4), which enclose the separation region (2) and are arranged adjacent thereto, wherein the conductive connection portion (3) is formed by inert material. The invention also relates to a corresponding electric integrated circuit (1a) and also to production methods for producing an array (1) of this type and for producing an electric integrated circuit (1a) of this type.

## Description

The present invention relates to an array formed from a multiplicity of electric integrated circuits, which is intended for separation, comprising a conductive connection to a central contact path for bond monitoring, wherein a separation region is provided in each case between adjacent integrated circuits and a separation from the array is implemented along the separation region for separation of the integrated circuits, and also to a method for producing an array of this type. The invention further relates to an electric integrated circuit produced from an array of this type and also to a method for production thereof.

Housed electric integrated circuits, for example molded array packages (MAPs), are often initially produced as an array that is later separated by separating the individual housings from one another along what is known as a separation region or separation channel. The production process can thus be made more effective.

A further rise in efficiency can be achieved by carrying out the wire bonding automatically in integrated circuits of this type, wherein the automated wire bonding machines used for this purpose verify the quality of the welded connections by means of a resistance measurement from the bond wire to the substrate (bond monitoring). To this end, a central contact path and a conductive connection electrically connected thereto are often provided on the substrate of the array, wherein the conductive connection is looped through all electric integrated circuits of the array. A conductive connection of this type, which generally consists of copper, was previously produced during the conventional metallization step for application of the conductive tracks.

Once the array has been separated into the individual integrated circuits, there is the problem that blank copper ends of the conductive connection to the central contact path are exposed, since the conductive connection interconnects all electric integrated circuits. The exposed copper material can react with harmful substances from the surrounding environment, resulting in undesired reaction products. Short circuits may be created as a result of this copper corrosion, or leakage currents may form, which are undesired.

Previously, this problem was counteracted by storing arrays of this type or the electric integrated circuits produced therefrom in an inert atmosphere as continuously as possible, and/or by eliminating sulfur and compounds thereof in the clean room. The disadvantage of the conventional approach is that, for example over the transport path, only a very imperfect protection of the blank copper surfaces is provided hereby, since the correct storage cannot always be ensured and/or sulfur cannot be eliminated completely from the surrounding environment of the electric integrated circuits. In particular, the avoidance of sulfur and its compounds is associated in the production environment with high outlay. Alternatively, the blank copper surfaces can be protected by an additional coating, which likewise entails a comparatively high outlay.

The object of the present invention is therefore to create an array formed from a multiplicity of electric integrated circuits or to create an electric integrated circuit separated therefrom, in which short circuits are prevented and leakage currents are avoided. A method is also to be specified, with which an array of this type or an electric integrated circuit of this type can be produced without greater additional expenditure compared to the conventional production method.

The above objects are achieved by an array formed from a multiplicity of electric integrated circuits having the features of claim 1, an electric integrated circuit having the features of claim 5, a method for producing an array of this type having the features of claim 6, and also a method for producing an electric integrated circuit of this type having the features of claim 9.

In accordance with the invention, an array according to the invention formed from a multiplicity of electric integrated circuits comprises at least one conductive connection portion, which extends between two contact paths which enclose the separation region and are arranged adjacent thereto, wherein the conductive connection portion is formed by inert material. The conductive connector portion, in the separation region, forms part of the conductive connection for the bond monitoring extending over the entire array.

In this case, the separation region comprises the channels of the array, along which the array is later separated, that is to say sawn or otherwise severed, in order to obtain individual electric integrated circuits.

The electric integrated circuit according to the invention is produced from an array of this type by separation along the separation region, for example by means of sawing.

In conjunction with the present invention, an inert material is understood to mean a material that is not reactive in the chemical sense or a material that is slow to react and that is much less heavily corroded than conventional copper or a conventional copper alloy. The inert material, in accordance with the invention, is formed from at least one material from the group comprising the elements gold, palladium, tantalum and nickel and also the alloy containing predominantly at least one of the mentioned elements.

The solution according to the invention is based on the concept of avoiding a corrosion of the open ends of the conductive connection after the separation process and therefore short circuits and leakage currents due to the replacement of the conventional copper/conductor connection merely in the separation region by inert material. The advantage of the solution according to the invention lies in the fact that the conductive connection to the central contact path is furthermore provided so that the bond monitoring by means of resistance measurement and therefore an assessment of the quality of the welded connection in the event of wire bonding is furthermore enabled in an unrestricted manner. Since copper is replaced by a more noble inert material only in the separation region, the material costs are only slightly increased.

In a preferred embodiment of the array according to the invention, the conductive connection portion in the separation region is formed as a bond bridge, preferably as a wire bond bridge, which is preferably produced by means of wedge-wedge bonding or ball-wedge bonding. This is a simple possibility for producing the conductive connection portion in the separation region by inert material. Due to this embodiment according to the invention, a greater distance is produced between the end of the bond bridge of the conductive connection portion that is open after the separation process and the contact structures arranged on the underside of the electric integrated circuit compared to the distance between the conventional copper metallization and the contact structures of the underside. The leakage path for currents is thus lengthened, and the likelihood for the occurrence of a short circuit is further reduced.

Furthermore, the array is formed as a molded array package (MAP) and/or the electric integrated circuit is formed as a ball grid array (BGA).

The method according to the invention for producing an array formed from a multiplicity of electric integrated circuits, which is intended for separation and comprises a conductive connection to a central contact path for bond monitoring, in particular includes the following steps:
- applying the conductive tracks to the array, wherein the separation region is recessed,
- closing the conductive connection to the central contact path by applying individual conductive connection portions, which extend between two previously produced contact paths which enclose the separation region and are arranged adjacent thereto, formed from inert material.

For production according to the invention of the electric integrated circuit, the array is then subjected to a separation step, in which the individual electric integrated circuits are detached from the array along the separation region, for example by means of sawing or breaking.

The method according to the invention for producing the array or the electric circuit causes a lower corrosion rate and therefore results in a lesser likelihood for the occurrence of short circuits and merely involves a negligible additional cost for the application of the conductive connection portions in the separation region, since this step can be carried out on the system necessary in any case for the bonding of the elements of the electric integrated circuits in order to start the bonding. There is thus no need for an additional manufacturing step.

The array according to the invention or the electric integrated circuit according to the invention and the method according to the invention for producing an array of this type or an electric integrated circuit of this type will be explained hereinafter on the basis of figures. Here, all features depicted and/or described form the subject matter of the invention, even independently of their summary in the claims or the dependency references of the claims.

In the figures:
- Fig. 1: shows a schematic view from above of an array according to the invention,
- Fig. 2: shows a schematic view from above of an electric integrated circuit according to the invention, and
- Fig. 3: shows a schematic cross-sectional view through a portion of the array according to the invention according to figure 1.

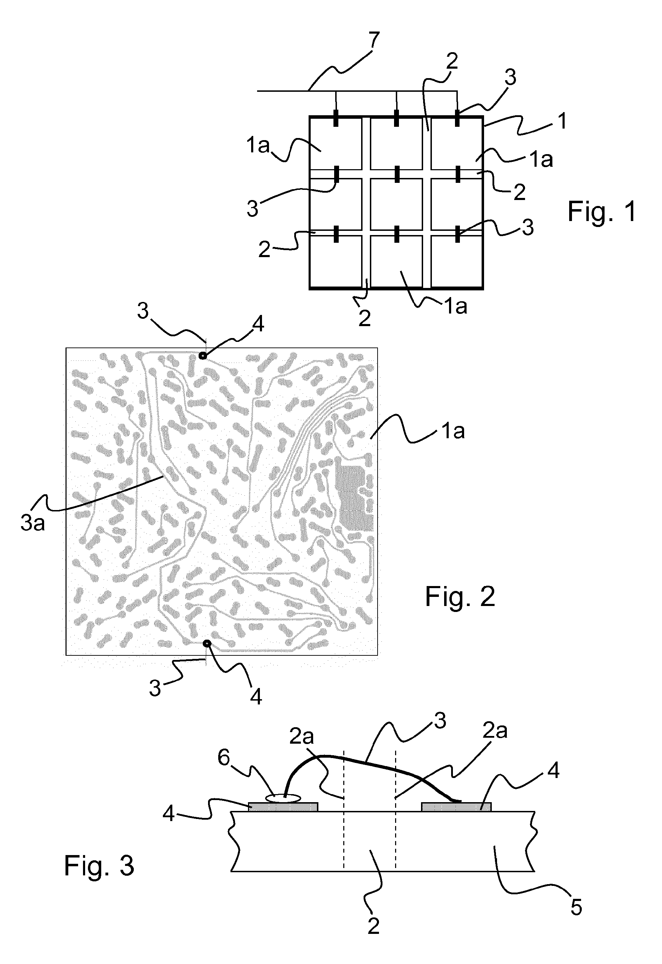

Figure 1 shows an array 1 according to the invention comprising nine electric integrated circuits 1a, wherein separation regions 2 are arranged between the integrated circuits 1a. A conductive connection consisting of the conductive connection portions 3, which extend over the separation regions 2, and further conductive structures 3a in the form of metallizations, which are provided on each integrated circuit 1a, extends over the entire array 1. The conductive connection extends over the entire array 1, comprises a central contact path (not illustrated), and can be used via a connection terminal 7 for bond monitoring.

The conductive connection portion 3 is preferably formed between two adjacent electric integrated circuits 1a of the array 1 by a wire bond bridge, which extends from a first contact path 4 of a first integrated circuit 1a to a second, adjacent contact path 4 of a second integrated circuit 1a, said circuits being separated from one another by a separation region 2 (see figure 3).

The production of the array from electric circuits starts with a suitably constructed substrate 5, which forms the basis for the further structure. This substrate 5, in the array arrangement, contains the repeating structures of the individual integrated circuits 1a (packages) with assembly faces for elements to be assembled of the integrated circuits, a potential net with the conductive structures 3a for the subsequent bond monitoring, which is connected in each case to the contact path 4, but in accordance with the invention also comprises interruptions in the separation regions 2, and further design elements necessary for the function and manufacturing cycle. On this substrate, in the case of die bonding, an adhesive is applied selectively to the assembly faces, and a die is placed thereupon in each case, that is to say an element of the integrated circuit provided for the first plane. After curing, each die is connected to the assembly face. Alternatively, dies can also be assembled by soldering or eutectic bonding.

In the next step, the wire bond conductive connection portions 3 are placed in accordance with the invention between the contact paths 4 of the individual integrated circuits 1a of the array 1, for example by means of wedge-wedge bonding or ball-wedge bonding, and the potential net for the bond monitoring is thus completed. In the case of ball-wedge bonding, a ball 6 illustrated in figure 3 is produced on one of the adjacent contact paths 4. The bond connections between the bond paths of the dies and the respective bond paths on the substrate are then formed, preferably on the same bonder and by means of the same bonding method. Here, bond monitoring is usually carried out by measuring the resistance of the current path from the bond tool via the corresponding connection terminal 7, the conductive connection portion 3, the constructive structure 3a, the bond connection to the die, from there via the adhesive and the die assembly face, or via the ground bond wire to the potential net. The potential net is for this purpose connected as a counter electrode to the measurement arrangement. With the aid of the bond monitoring, the quality of each individual bond connection is assessed. In the event of a fault, the integrated circuit 1a involved is rejected or reworked. In this way, a very high process reliability is ensured in spite of the normally very high number of bond connections. Further dies can then be assembled and bonded, depending on design.

Once the assembly cycle is complete, the substrate 5 and the assembled integrated circuits 1a are encased by a plastic (not illustrated), wherein the underside of the substrate 5 remains unwetted. This normally occurs in a casting mold by means of transfer molding. The underside of the substrate corresponding to the array arrangement is then provided with an interface that can be soldered (for example balls of solder). After inscription of the individual housed electric integrated circuits 1a in the array 1, the array is sawn along the separation regions 3 in such a way that the desired individual electric integrated circuits 1a are obtained. The region of the separation regions removed by the sawing process is indicated in figure 3 by the dashed lines 2a.

Since the connection of the potential net between the electric integrated circuits 1a has been created by wire bond conductive connection portions 3, the ends of this conductive connection portion 3 are now exposed at each of the sawn edges. Since the conductive connection portion 3 consists of an inert material such as gold, harmful corrosion can no longer take place, as would be feared in the case with the conventional substrate metallization formed from copper.

### List of reference signs

- 1: array
- 1a: electric integrated circuit
- 2: separation region
- 2a: dashed line
- 3: conductive connection portion
- 3a: conductive structure
- 4: contact path
- 5: substrate
- 6: ball
- 7: connection terminal

## Claims

1. An array (1) formed from a multiplicity of electric integrated circuits (1a), comprising a conductive connection, extending over all integrated circuits (1a) of the array (1), to a central contact path for bond monitoring, wherein a separation region (2) is provided in each case between adjacent integrated circuits (1a) and a separation from the array (1) is implemented along the separation region in order to separate the integrated circuits (1a), **characterized in that** at least one conductive connection portion (3) is provided and extends between two contact paths (4) of the adjacent integrated circuits (1a), which enclose the separation region (2), wherein the conductive connection portion (3) is formed by inert material.

2. The array (1) as claimed in claim 1, **characterized in that** the conductive connection portion (3) is formed as a bond bridge, preferably as a wire bond bridge.

3. The array (1) as claimed in one of the preceding claims, **characterized in that** the inert material is formed from at least one material from the group comprising the elements gold, palladium, tantalum and nickel and also the alloy containing predominantly at least one of the mentioned elements.

4. The array (1) as claimed in one of the preceding claims, **characterized in that** the array is formed as a molded array package and/or the electric integrated circuit is formed as a ball grid array.

5. An electric integrated circuit (1a) produced from an array (1) as claimed in one of the preceding claims by separation along the separation region (2).

6. A method for producing an array (1) formed from a multiplicity of electric integrated circuits (1a), said array being intended for separation and having a conductive connection to a central contact path for bond monitoring, said method comprising the following steps:
- applying conductive tracks (3 a) to the array, wherein the separation region (2) is recessed,
- closing the conductive connection to the central contact path by applying individual conductive connection portions (3), which extend between two contact paths (4) which enclose the separation region (2) and are arranged adjacent thereto, formed from inert material.

7. The method as claimed in claim 6, **characterized in that** conductive connection portions (3) are provided as wire bridges.

8. The method as claimed in one of claims 6 or 7, **characterized in that** the inert material is formed from at least one material from the group comprising the elements gold, palladium, tantalum and nickel and also the alloy containing predominantly at least one of the mentioned elements.

9. A method for producing an electric integrated circuit (1a), wherein an array (1) formed from a multiplicity of electric integrated circuits (1a) as claimed in one of claims 6 to 8 is initially produced and the array (1) is then subjected to a separation step, in which the individual electric integrated circuits (1a) are detached from the array (1) along the separation region (2), for example by means of sawing or breaking.
